Europäisches Patentamt

European Patent Office

Office européen des brevets

(19)

(11) Veröffentlichungsnummer : **0 045 020**
**B1**

(12) **EUROPÄISCHE PATENTSCHRIFT**

(45) Veröffentlichungstag der Patentschrift :
22.10.86

(51) Int. Cl.⁴ : **G 11 C 11/24, H 03 K 3/356**

(21) Anmeldenummer : **81105636.5**

(22) Anmeldetag : **17.07.81**

(54) **Dynamischer Leseverstärker für MOS-Halbleiterspeicher.**

(30) Priorität : **29.07.80 DE 3028754**

(43) Veröffentlichungstag der Anmeldung :
**03.02.82 Patentblatt 82/05**

(45) Bekanntmachung des Hinweises auf die Patenterteilung : **22.10.86 Patentblatt 86/43**

(84) Benannte Vertragsstaaten :
**FR GB**

(56) Entgegenhaltungen :
**DE-A- 1 774 948**
**DE-A- 2 758 810**
**GB-A- 2 018 076**
**US-A- 4 061 999**
**IBM TECHNICAL DISCLOSURE BULLETIN, Band 17, Nr. 9, Februar 1975, Seiten 2582-2583, New York, USA, J.L. CHU et al.: "Low-power, high-speed sense latch"**

(73) Patentinhaber : **Siemens Aktiengesellschaft Berlin und München**
**Wittelsbacherplatz 2**
**D-8000 München 2 (DE)**

(72) Erfinder : **Url, Karlheinz, Dr. rer.nat**
**Cimbernstrasse 89**
**D-8000 München 70 (DE)**

**Beschreibung**

Die Erfindung betrifft einen dynamischen Leseverstärker für MOS-Halbleiterspeicher nach dem Oberbegriff des Patentanspruches.

In MOS-Halbleiterspeicherbausteinen mit 1-Transistor-Speicherzellen müssen kleine Signale mit einem Leseverstärker verstärkt werden. Die Leseverstärker sind als Flip-Flops ausgeführt und benutzen bei dynamischem Betrieb die Informationsleitungen als Spannungsversorgung. Aus diesem Grund wird bei der Signalverstärkung der Signalpegel für die logische « 1 »-Information auf den Informationsleitungen abgesenkt und es kann nur ein niedrigeres Potential in die Speicherzelle zurückgeschrieben werden. Dies führt bei nächsten Auslesezyklus zu einem verringerten Lesesignal.

Mit statischen anstelle von dynamischen Leseverstärkern wird der Signalpegel für die logische «.1 » regeneriert, der auftretende Querstrom bei der Entladung der Signalleitung für die logische « 0 »-Information führt jedoch zu einer unzulässig hohen Verlustleistung. Beim dynamischen Leserverfahren wurde bisher auf die Signalpegelregenerierung verzichtet.

Aus « IBM Technical Disclosure Bulletin », Band 17, Nr. 9, Februar 1975, Seiten 2582-2583, ist ein gattungsgemäßer Leseverstärker bekann. Bei diesem ist es möglich, den logischen « 1 »-Pegel nach einem Auslesevorgang ohne zusätzliche Verlustleistung zu regenerieren. Die Arbeitsgeschwindigkeit eines solchen Leseverstärkers genügt jedoch den Herstellern und Anwendern von Halbleiterspeichern noch nicht. Des weiteren lassen sich in einem Halbleiterspeicher vorgesehene Fehlerkorrekturschaltungen mit einem Leseverstärker der vorstehenden Art nur unter Verlust an Arbeitsgeschwindigkeit betreiben. Des weiteren ist es bei Verwendung gattungsgemäßer Leseverstärker in einem Halbleiterspeicher, dessen Speicherzellenmatrix in Blöcke aufgeteilt ist, notwendig, Informationsleitungen über eine Datenweiche auf einen Datenausgangsverstärker durchzuschalten. Dies bedingt wiederum einen Verlust an Arbeitsgeschwindigkeit, d. h. die Speicherzugriffszeit erhöht sich. Die Zugriffszeit eines Halbleiterspeichers jedoch ist ein wichtiges Kriterium für Anwender bei der Beurteilung eines Halbleiterspeichers, das über Erfolg oder Mißerfolg eines Halbleiterspeichers auf dem Markt entscheiden kann.

Aus « IBM Technical Disclosure Bulletin », Band 22, Nr. 4, September 1979, Seiten 1411-1412, ist ein Leseverstärker bekannt, der zwischen den Ausgängen eines aus kreuzgekoppelten Transistoren bestehenden Lese-Flip-Flops und den Bitleitungen Abtrenntransistoren aufweist. Diese entkoppeln das Lese-Flip-Flop während des Bewertungsvorganges von den hohe Kapazitäten aufweisenden Bitleitungen. Bei der Regenerierung des logischen « 1 »-Pegels der ausgelesenen Speicherzelle über die Bitleitungen wird jedoch eine zusätzliche Verlustleistung benötigt.

Außerdem ist die Arbeitsgeschwindigkeit dieses Leseverstärkers geringer als bei dem zuvor genannten.

Aufgabe der vorliegenden Erfingung ist es deshalb, einen Leseverstärker zu schaffen, der den nachfolgenden Bedingungen genügt :

a) Höhere Arbeitsgeschwindigkeit, d. h. kürzere Speicherzugriffszeit,

b) keine zusätzliche Verlustleistung beim Regenerieren des logischen « 1 »-Pegels,

c) Möglichkeit des Betreibens von Fehlerkorrekturschaltungen in Halbleiterspeichern ohne Verlust an Arbeitsgeschwindigkeit,

d) Möglichkeit des Einsparens einer Datenweiche bei Verwendung in einem Halbleiterspeicher mit Aufteilung der Speicherzellenmatrix in Blöcke.

Diese Aufgabe wird erfindungsgemäß gelöst durch die kennzeichnenden Merkmale des Patentanspruches.

Durch diese Maßnahmen wird erreicht, daß in die Speicherzelle im Falle einer logischen « 1 » ein maximales Zellenpotential zurückgeschrieben werden kann, ohne daß dadurch die Verlustleistung erhöht wird.

Bei der Anwendung als externer Leseverstärker stehen auf den externen Informationsleitungen BEV, BEVQ die komplementären Signale früher mit ihrem Endpegel zur Verfügung als auf den Informationsleitungen BE, BEQ und können schneller an den Datenausgang des Speicherbausteins durchgeschaltet werden. Auf diese Weise kann die Zugriffszeit verkürzt werden.

Benutzt man die Schaltung für die Bewertung der Lesesignale des Zellenfeldes (interner Leseverstärker), so kann die auf den Datenausgängen BEV, BEVQ schneller zur Verfügung stehende Information zur Ansteuerung einer auf dem Speicherbaustein integrierten Fehlerkorrekturschaltung dienen.

Wenn die Speicherzellenmatrix in Blöcke unterteilt ist, mußten bisher mehrere Informationsleitungen BE1/BE1Q, BE2/BE2Q... mit einer Weiche auf den Datenausgangsverstärker durchgeschaltet werden. Bei Anwendung der externen Leseverstärkerschaltung können die einzelnen Leseverstärker mit dekodierten Bewertertakten $\phi$B1, $\phi$B2, ... zur Signalverstärkung veranlaßt werden. Die jeweilige Information kann dann über die gemeinsamen Datenleitungen BEV, BEVQ ohne Weiche an den Datenausgangstreiber durchgeschaltet werden. Auch diese Organisation der Informationsübertragung bewirkt eine Verkürzung der Zugriffszeit.

Anhand einer bekannten Schaltung nach Fig. 1 sowie der Figuren 2 bis 5 wird die Erfindung näher erläutert.

Es zeigen :

Figur 1 einen bekannten dynamischen Leseverstärker,

Figur 2 einen Leseverstärker nach der Erfindung,

Figur 3 das zugehörige Taktdiagramm zum Leseverstärker nach Fig. 2,

Figur 4 eine bekannte Organisation eines Speicherbausteins,

Figur 5 eine Organisation eines Speicherbausteins bei Verwendung von Leseverstärkern nach der Erfindung.

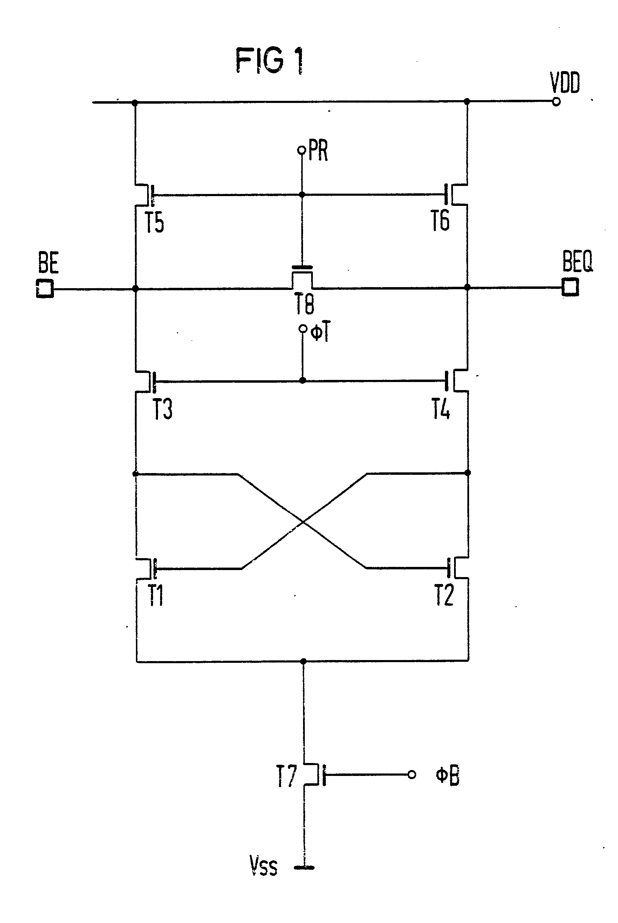

Zur Bewertung eines an den Informationsleitungen BE, BEQ eines bekannten Leseverstärkers nach Fig. 1 anliegenden Lesesignals wird eine Flip-Flop-Anordnung als Differenzverstärker eingesetzt. Die Schaltung besteht aus dem Flip-Flop, gebildet aus den Schalttransistoren T1 und T2, den zwei Abtrenntransistoren T3 und T4 zum Abtrennen der Informationsleitungen BE und BEQ und dem Durchschaltetransistor T7 zum Durchschalten des Flip-Flop-Fußpunktes an Vss. Mit Hilfe der Ladetransistoren T5 und T6 werden die Informationsleitungen vorgeladen und mit Transistor T8 symmetriert.

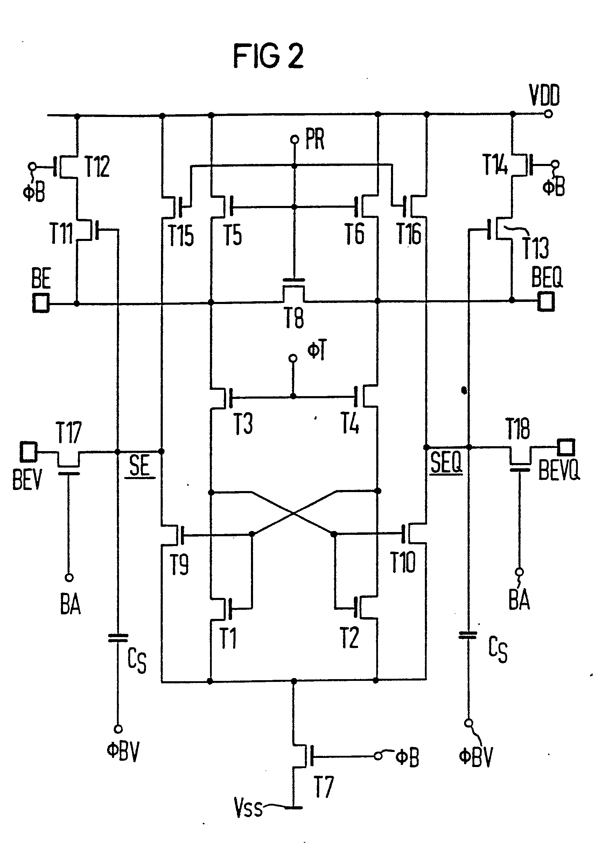

Der erfindungsgemäße dynamische Leseverstärker für MOS-Halbleiterspeicher ist in Fig. 2 dargestellt. Er enthält ein Flip-Flop mit zwei ersten Schalttransistoren T1, T2, dessen Fußpunkt über einen Durchschaltetransistor T7 mittels einer ersten Taktspannung $\phi B$ an Masse Vss legbar ist. Er enthält des weiteren erste Informationsleitungen BE, BEQ und erste Ladetransistoren T5, T6. Diese ermöglichen mittels Ansteuerung durch eine zweite Taktspannung PR ein Aufladen der ersten Informationsleitungen BE, BEQ auf eine Versorgungsspannung VDD. Der erfindungsgemäße Leseverstärker weist des weiteren zwei zweite Schalttransistoren T9, T10 auf, deren Torelektroden mit den Torelektroden der ersten Schalttransistoren T1, T2 verbunden sind und deren Quellenelektroden mit den Quellenelektroden der ersten Schalttransistoren T1, T2 verbunden sind. Außerdem enthält der erfindungsgemäße Leseverstärker zwei weitere Ladetransistoren T15, T16, deren Kanalstrecken einerseits mit der Versorgungsspannung VDD verbunden sind und andererseits mit den Senkenelektroden der zweiten Schalttransistoren T9, T10. Die Verbindungen der weiteren Ladetransistoren T15, T16 mit den zweiten Schalttransistoren T9, T10 bilden Verbindungspunkte SE, SEQ. Die Torelektroden der beiden weiteren Ladetransistoren T15, T16 sind mit der zweiten Taktspannung PR verbunden. Zwischen den Verbindungspunkten SE, SEQ und einer dritten Taktspannung $\phi BV$ sind Kapazitäten $C_s$ angeordnet. Zwischen der Versorgungsspannung VDD und jeder der ersten Informationsleitungen BE, BEQ ist des weiteren, parallel zu den ersten Ladetransistoren T5, T6, eine Reihenschaltung der Kanalstrecken eines dritten Schalttransistors T11 ; T13 mit einem weiteren Schalttransistor T12 ; T14 angeordnet. Die Torelektroden der dritten Schalttransistoren T11, T13 sind dabei mit den Verbindungspunkten SE, SEQ verbunden und die der weiteren Schalttransistoren T12, T14 mit der ersten Taktspannung $\phi B$. Zwischen Ausgängen des Flip-Flops und den ersten Informationsleitungen BE, BEQ sind erste Abtrenntransistoren T3, T4 angeordnet, die über ihre Torelektroden von einer vierten Taktspannung $\phi T$ gesteuert werden. Des weiteren enthält der erfindungsgemäße Leseverstärker zweite Informationsleitungen BEV, BEVQ. Zwischen diesen zweiten Informationsleitungen BEV, BEVQ und den Verbindungspunkten SE, SEQ ist jeweils ein weiterer, zweiter Abtrenntransistor T17 ; T18 angeordnet, dessen Torelektrode mit einer fünften Taktspannung BA verbunden ist.

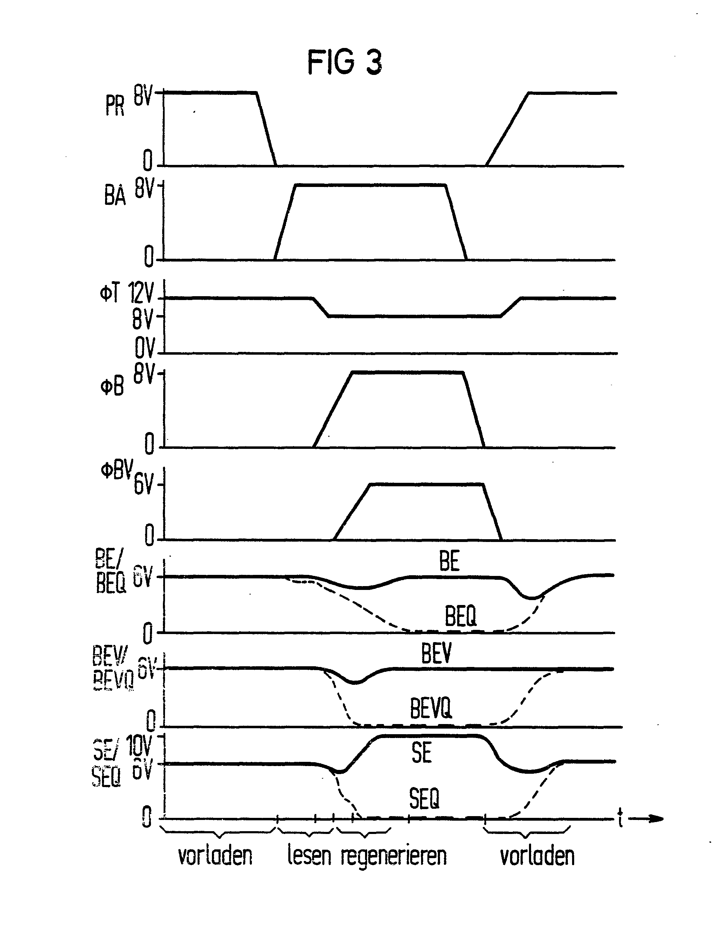

Anhand des Impulsdiagramms nach Fig. 3 wird die Funktionsweise der Schaltung nach Fig. 2 näher beschrieben. Das Vorladen des Leseverstärkers erfolgt damit, daß die zweite Taktspannung PR eingeschaltet ist. Die Stromversorgung ist damit angelegt und die beiden ersten Informationsleitungen BE, BEQ sowie die Verbindungspunkte SE, SEQ werden vorgeladen. Gleichzeitig werden über den Symmetriertransistor T8 die ersten Informationsleitungen BE und BEQ auf gleiches Potential symmetriert. Anschließend wird die zweite Taktspannung PR ausgeschaltet und der Leseverstärker für den dynamischen Betrieb freigegeben.

Zur Einleitung des Auslesevorgangs wird die fünfte Taktspannung BA eingeschaltet. Gleichzeitig wird die jeweilige Bitleitung und damit ein entsprechendes Speicherelement ausgewählt und die Information auf die ersten Informationsleitungen BE, BEQ durchgeschaltet. Die weiteren Abtrenntransistoren T17, T18 verbinden die Verbindungspunkte SE, SEQ mit den zweiten Informationsleitungen BEV, BEVQ. Dann wird die vierte Taktspannung $\phi T$ abgesenkt, wodurch die Kapazitäten der ersten Informationsleitungen BE, BEQ vom Leseverstärker abgetrennt werden, um ein schnelleres Kippen des Flip-Flops zu ermöglichen und um den Signalpegel für die logische « 1 » z. B. auf der Informationsleitung BE nicht zu weit abzusenken.

Gleichzeitig wird die erste Taktspannung $\phi B$ eingeschaltet, wodurch der Flip-Flop-Fußpunkt auf Null Volt entladen und das Flip-Flop entsprechend der anliegenden Information gesetzt wird. Im Beispiel nach Fig. 3 wird die eine erste Informationsleitung BEQ entladen, während die andere erste Informationsleitung BE leicht abgesenkt wird, da die ersten Informationsleitungen BE, BEQ für den dynamischen Leseverstärker als Versorgungsspannung und die ersten Abtrenntransistoren T3, T4 als Lasttransistoren wirken. Über die zweiten Schalttransistoren T9, T10, die von den Flip-Flop-Ausgängen geschaltet werden, werden die Informationen von den ersten Informationsleitungen BE, BEQ auf die Verbindungspunkte SE, SEQ und über die zweiten Abtrenntransistoren T17, T18 auf die zweiten Informationsleitungen BEV, BEVQ übertragen. Die kleineren Kapazitäten der zweiten Informationsleitungen BEV, BEVQ können schneller entladen werden als die von der Speicherorganisation vorgegebenen großen Kapazitäten der ersten Informationsleitungen BE, BEQ.

Beim Regenerieren wird zunächst die dritte Taktspannung φBV eingeschaltet. Mit Hilfe der Kapazitäten $C_S$ wird in die Verbindungspunkte SE, SEQ ein Strom eingekuppelt. Abhängig von der Richtung, in die das Flip-Flop gekippt wurde, wird einer der Verbindungspunkte (z. B. SE) auf hohes Potential angehoben, während der andere der Verbindungspunkte (z. B. SEQ) auf Null Volt gehalten wird. Der dem einen der beiden Verbindungsknoten (SE) zugeordnete zweite Schalttransistor (T9) wird gesperrt und der andere zweite Schalttransistor (T10) bleibt leitend.

Der angehobene Verbindungspunkt SE gibt den Strompfad über den einen dritten Schalttransistor T11 und den weiteren Schalttransistor T12 der einen der beiden Reihenschaltungen frei. Der Signalpegel der einen ersten Informationsleitung BE wird dadurch regeneriert. Der auf Null Volt gehaltene Verbindungspunkt SEQ sperrt den anderen dritten Schalttransistor T13 der anderen der beiden Reihenschaltungen. Die zweite Informationsleitung BEQ wird somit nicht mit der Versorgungsspannung VDD verbunden, so daß kein Querstrom fließt und keine zusätzliche Verlustleistung auftritt.

Nach Übernahme der Information von den zweiten Informationsleitungen BEV, BEVQ in den Datenausgangstreiber werden bei Zyklusende die Taktleitungen für die erste, dritte und fünfte Taktspannung φB, φBV, BA abgeschaltet.

Durch Einschalten der zweiten Taktspannung PR beginnt das Vorladen der Informationsleitungen BE, BEQ, BEV, BEVQ und der Verbindungspunkte SE, SEQ in der Zykluspause von neuem und damit wiederum ein neuer Zyklus.

Die Schaltungsanordnung nach Fig. 2 ermöglicht ein schnelleres Durchschalten der Information von den ersten Informationsleitungen BE, BEQ über die zweiten Informationsleitungen BEV, BEVQ an den Datenausgangstreiber. Die übrigen Eigenschaften der Schaltungsanordnung wie die Vorteile durch eine symmetrische Auslegung werden durch die erfindungsgemäß eingefügten Transistoren, Kapazitäten und Informationsleitungen nicht beeinflußt.

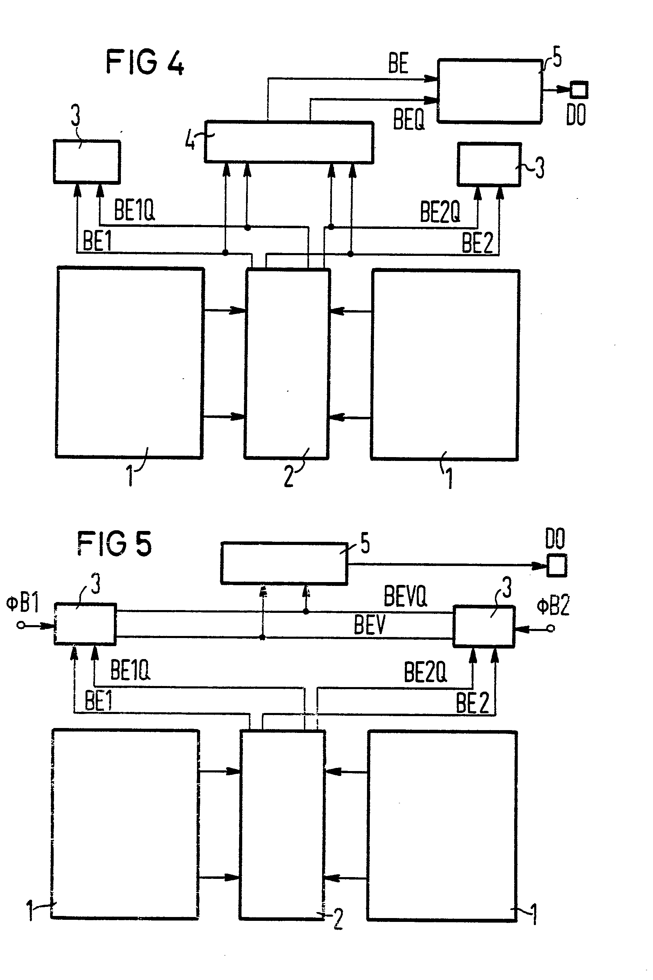

Fig. 4 zeigt die Organisation eines Speicherbausteins und einer Datenweiche in der herkömmlichen Art. Der interne Leseverstärker 2 wird dabei jeweils von einem linken und einem rechten Zellenblock 1 gesteuert. Die Ausgänge BE1, BE2 bzw. BE1Q und BE2Q der externen Bitleitungen werden jeweils paarweise an die externen Leseverstärker 3 geführt, wo das Signal verstärkt und auf den gleichen Leitungen jeweils der Weiche 4 zugeführt wird, deren Ausgänge BE, BEQ an einen Treiber 5 geführt sind, von wo aus das Datensignal auf die Datenleitung DO gegeben wird. Die Weiche 4 ist dabei erforderlich, um jeweils den linken oder rechten Leseverstärker 3 bei gleichzeitigem Auftreten von Signalen zu privilegieren.

Fig. 5 zeigt eine Speicherorganisation unter Anwendung von Leseverstärken nach der Erfindung. Durch das Vorhandensein der zusätzlichen Informationsleitungen BEV und BEVQ ist es nunmehr möglich, die externen Leseverstärker über die Torsignale φB1, φB2 getrennt zu takten und dadurch eine zusätzliche Weiche zu vermeiden. Die Ausgänge der beiden externen Leseverstärker 3 werden unmittelbar auf die Treiberstufe 5 geführt. Dadurch wird der weitere Vorteil erreicht, daß auch durch die Speicherorganisation selbst eine zusätzliche Zeitverkürzung beim Auslesen aus dem Speicher eintritt, so daß die Zeitverkürzung sowohl durch den Aufbau des Leseverstärkers selbst als auch durch die dadurch möglich werdende Organisation hervorgerufen wird.

**Patentanspruch**

Dynamischer Leseverstärker für MOS-Halbleiterspeicher mit einem zwei erste Schalttransistoren (T1, T2) enthaltenden Flip-Flop, dessen Fußpunkt über einen Durchschaltetransistor (T7) mittels einer ersten Taktspannung (0B) an Masse (Vss) legbar ist, mit ersten Informationsleitungen (BE, BEQ), mit ersten Ladetransistoren (T5, T6), durch die, gesteuert über eine zweite Taktspannung (PR) die ersten Informationsleitungen (BE, BEQ) auf eine Versorgungsspannung (VDD) aufladbar sind, mit zwei zweiten Schalttransistoren (T9, T10), deren Torelektroden bzw. Quellenelektroden mit den jeweiligen Tor- bzw. Quellenelektroden der ersten Schalttransistoren (T1, T2) verbunden sind, mit zwei weiteren Ladetransistoren (T15, T16), deren Kanalstrecke einerseits mit der Versorgungsspannung (VDD) und andererseits mit den Senkenelektroden der beiden zweiten Schalttransistoren (T9, T10) verbunden sind, wobei die Verbindungen der weiteren Ladetransistoren (T15, T16) mit den zweiten Schalttransistoren (T9, T10) Verbindungspunkte (SE, SEQ) bilden, mit Verbindungen der Torelektroden der beiden weiteren Ladetransistoren (T15, T16) mit der zweiten Taktspannung (PR), mit Kapazitäten ($C_S$), die jeweils an ihrer einen Elektrode mit einem der Verbindungspunkte (SE, SEQ) und mit ihrer anderen Elektrode mit einer dritten Taktspannung (φBV) verbunden sind, mit zwei dritten Schalttransistoren (T11, T13), die mit ihren Kanalstrecken parallel zu den ersten Ladetransistoren (T5, T6) zwischen der Versorgungsspannung (VDD) und den ersten Informationsleitungen (BE, BEQ) angeordnet sind und deren Torelektroden mit den Verbindungspunkten (SE, SEQ) verbunden sind, dadurch gekennzeichnet,

— daß zwischen Ausgänge des Flip-Flops und den ersten Informationsleitungen (BE, BEQ) durch eine vierte Taktspannung (φT) gesteuerte erste Abtrenntransistoren (T3, T4) angeordnet sind,

— daß zwischen der Versorgungsspannung (VDD) und den dritten Schalttransistoren (T11, T13) jeweils ein weiterer Schalttransistor (T12 ; T14) mit seiner Kanalstrecke in Reihe zu dem jeweiligen dritten Schalttransistor (T11 ; T13) angeordnet ist, dessen Torelektrode mit der ersten Taktspannung (φB) verbunden ist,

— daß der Leseverstärker zweite Informationsleitungen (BEV, BEVQ) aufweist,

— daß zwischen den Verbindungspunkten (SE, SEQ) und den zweiten Informationsleitungen (BEV, BEVQ) jeweils ein weiterer zweiter Abtrenntransistor (T17 ; T18) angeordnet ist, und

— daß die Torelektroden der weiteren, zweiten Abtrenntransistoren (T17, T18) mit einer fünften Taktspannung (BA) verbunden sind.

## Claim

A dynamic read amplifier for MOS-semiconductor stores, with a flip-flop stage containing two first switching transistors (T1, T2) whose common low-point connection can be connected to earth (Vss) via a switch-through transistor (T7) by a first clock voltage ($\phi$B), first information lines (BE, BEQ), first charging transistors (T5, T6) which can charge the first information lines (BE, BEQ) to a supply voltage (VDD) under the control of a second clock voltage (PR), two second switching transistors (T9, T10) whose gate electrodes and source electrodes are respectively connected to the gate electrodes and source electrodes of the first switching transistors (T1, T2), two further charging transistors (T15, T16) whose conductor paths are connected at one end to the supply voltage (VDD) and at the other end to the drain electrodes of the two second switching transistors (T9, T10), the connections between the further charging transistors (T15, T16) and the second switching transistors (T9, T10) forming junction points (SE, SEQ) and the gate electrodes of the two further charging transducers (T15, T16) being connected to the second clock voltage (PR), respective capacitors ($C_S$) each having one electrode connected to one of the junction points (SE, SEQ) and their other electrode to a third clock voltage ($\phi$BV), two third switching transistors (T11, T13) whose conductor paths extend parallel to the first charging transistors (T5, T6) between the supply voltage (VDD) and the first information lines (BE, BEQ) and whose gate electrodes are connected to the junction points (SE, SEQ), characterised in

— that first isolating transistors (T3, T4) controlled by a fourth clock voltage ($\phi$T) are arranged between the outputs of the flip-flop stage and the first information lines (BE, BEQ),

— that a further switching transistor (T12 ; T14) is arranged between the supply voltage (VDD) and the third switching transistors (T11, T13) with its conductor path in series with the third switching transistor (T11 ; T13) which have their gate electrodes connected to the first clock voltage ($\phi$B),

— that the read amplifier comprises second information lines (BEV, BEVQ),

— that two further, second isolating transistors (T17 ; T18) are arranged between the junction points (SE, SEQ) and the second information lines (BEV, BEVQ), and

— that the gate electrodes of the further second isolating transistors (T17, T18) are connected to a fifth clock voltage (BA).

## Revendication

Amplificateur de lecture dynamique pour mémoires à semi-conducteurs MOS, comprenant une bascule, contenant deux premiers transistors de commutation (T1, T2), dont la base peut être connectée à la masse (Vss) à travers un transistor de connexion (T7) au moyen d'une première tension de commande ($\phi$B), comprenant des premières lignes d'informations (BE, BEQ) avec des premiers transistors de charge (T5, T6) par lesquels, sous la commande d'une seconde tension de commande (PR), les premières lignes d'informations (BE, BEQ) peuvent être chargées à une tension d'alimentation (VDD), comprenant deux seconds transistors de commutation (T9, T10) dont les électrodes de grille et les électrodes de source sont connectées respectivement aux électrodes de grille et aux électrodes de source correspondantes des premiers transistors de commutation (T1, T2), avec deux transistors de charge supplémentaires (T15, T16) dont les circuits de canal sont connectés d'une part à la tension d'alimentation (VDD) et d'autre part aux électrodes de source des deux seconds transistors de commutation (T9, T10), les connexions des transistors de charge supplémentaires (T15, T16) avec les seconds transistors de commutation (T9, T10) formant des points de liaison (SE, SEQ), avec des connexions entre les électrodes de grille des deux transistors de charge supplémentaires (T15, T16) et la seconde tension de commande (PR), avec des capacités ($C_S$) qui sont chacune connectées par une de leurs électrodes à l'un des points de liaison (SE, SEQ) et par leur autre électrode à une troisième tension de commande ($\phi$BV), et avec deux troisièmes transistors de commutation (T11, T13) qui sont disposés avec leurs circuits de canal parallèlement aux premiers transistors de charge (T5, T6) entre la tension d'alimentation (VDD) et les premières lignes d'informations (BE, BEQ) et dont les électrodes de grille sont connectées aux points de liaison (BE, BEQ), caractérisé en ce

— que des premiers transistors de coupure (T3, T4), commandés par une quatrième tension de commande ($\phi$T), sont disposés entre des sorties de la bascule et les premières lignes d'informations (BE, BEQ),

— qu'un transistor de commutation supplémentaire (T12 ; T14), dont l'électrode de grille est connectée à la première tension de commande ($\phi$B), est disposé par son circuit de canal entre la tension d'alimentation (VDD) et chacun des troisièmes transistors de commutation (T11, T13), en série avec ce dernier,

— que l'amplificateur de lecture présente des deuxièmes lignes d'informations (BEV, BEVQ),

— qu'un second transistor de coupure supplémentaire (T17 ; T18) est disposé chaque fois entre les points de liaison (SE, SEQ) et les deuxièmes lignes d'informations (BEV, BEVQ) et

— que les électrodes de grille des seconds transistors de coupure supplémentaires (T17, T18) sont connectées à une cinquième tension de commande (BA).

# FIG 1

FIG 2

# FIG 3

FIG 4

FIG 5